# FASCICULE DE BREVET EUROPEEN

(11) **EP 3 351 064 B1**
(45) Date de publication et mention de la délivrance du brevet: **15.05.2024**
(21) Numéro de dépôt: 16769939.6
(22) Date de dépôt: 15.09.2016
(51) Int. Cl.: H05K 3/34, H05K 1/09, H05K 3/32

(54) **PROCEDE D'ASSEMBLAGE PAR FRITTAGE D'ARGENT SANS PRESSION**
MONTAGEVERFAHREN DURCH SILBERSINTERN OHNE DRUCK
ASSEMBLY METHOD BY SILVER SINTERING WITHOUT PRESSURE

(30) Priorité: 15.09.2015 FR 1558625
(43) Date de publication de la demande: 25.07.2018
(73) Titulaire: Safran Electronics & Defense, 92100 Boulogne-Billancourt (FR)
(72) Inventeur: GEOFFROY, Thomas, 92100 Boulogne-billancourt (FR); RIOU, Jean-Christophe, 92100 Boulogne-billancourt (FR); BAILLY, Eric, 92100 Boulogne-billancourt (FR)
(74) Mandataire: Cabinet Boettcher
(86) Numéro de dépôt international: PCT/EP2016/071866
(87) Numéro de publication internationale: WO 2017/046266

(56) Documents cités:
- EP-A1- 2 278 593
- US-A1- 2003 108 664
- US-A1- 2009 162 557
- US-A1- 2011 084 369
- US-A1- 2011 186 340
- US-A1- 2012 055 707
- WONG WAI KWAN ET AL: "Low temperature sintering process for deposition of nano-structured metal for nano IC packaging", ELECTRONICS PACKAGING TECHNOLOGY, 2003 5TH CONFERENCE (EPTC 2003) DEC. 10-12, 2003, PISCATAWAY, NJ, USA,IEEE, 10 décembre 2003 (2003-12-10), pages 551-556, XP010687352, ISBN: 978-0-7803-8205-3
- ZHANG ZHIYE ET AL: "NANOSCALE SILVER SINTERING FOR HIGH-TEMPERATURE PACKAGING OF SEMICONDUCTOR DEVICES", MATERIALS PROCESSING AND MANUFACTURING DIVISION. GLOBAL SYMPOSIUM SURFACES AND INTERFACES IN NANOSTRUCTURED MATERIALS AND TRENDSIN LIGA, MINIATURIZATION AND NANOSCALE MATERIALS, XX, XX, 1 janvier 2004 (2004-01-01), pages 129-135, XP001248317,

## Description

### DOMAINE DE L'INVENTION

La présente invention concerne le domaine de l'assemblage de pièces et plus particulièrement des composants électroniques.

### ARRIERE PLAN DE L'INVENTION

Il est connu d'assembler un composant électronique, tel qu'un condensateur multicouche en céramique, par brasage, notamment au plomb, sur un substrat en silicium. Cette technique d'assemblage met en oeuvre des températures inférieures à la température de fusion des éléments à assembler. De telles températures permettent de réduire l'impact de la chaleur sur les éléments à assembler, comme par exemple une dégradation de leurs propriétés mécaniques ou une oxydation. De tels procédés de brasage se prêtent bien à des modes de production automatisés.

Lorsqu'un assemblage électronique est soumis à des variations de température de forte amplitude (de l'ordre d'au moins 150°C, par exemple -65°C / +250°C), l'assemblage est soumis à de fortes variations de contraintes mécaniques en raison des différences de dilatation thermique entre les matériaux utilisés. Lorsque ce phénomène se produit de façon cyclique, l'assemblage est exposé à de l'usure par fatigue.

Parmi les brasures couramment utilisées dans le domaine de l'électronique, les brasures utilisant des alliages au plomb sont les plus résistantes aux cycles thermiques de grande amplitude. Cependant, le plomb est hautement toxique pour l'homme comme pour l'environnement et sa mise en oeuvre est désormais interdite.

Alternativement aux brasures contenant du plomb, il est connu de réaliser des assemblages de composants mettant en oeuvre des liaisons en métal fritté sous pression qui résistent aux cycles thermiques de grande amplitude. Dans ce mode d'assemblage, une poudre métallique est déposée entre deux éléments à assembler et l'ensemble ainsi formé est mis sous pression puis chauffé à une température modérée de l'ordre de 240°C.

L'assemblage par frittage permet de former, entre les éléments assemblés, des joints d'attache dont les points de fusion sont bien plus élevés que ceux des alliages utilisés couramment pour les brasures. Généralement, plus le point de fusion du joint d'attache est élevé, meilleures sont ses propriétés mécaniques, notamment sa résistance à la fatigue.

Toutefois, lors d'un assemblage par frittage, il peut se former des vides entre les grains constituant le joint de métal fritté. Ces vides sont des lacunes de matériau ayant des dimensions de l'ordre du micromètre. Si la porosité (rapport entre le volume des vides et le volume total d'un milieu poreux) d'un joint réalisé par frittage est excessive, sa résistance aux cycles thermiques de grande amplitude sera faible et des défaillances surviendront au bout d'un nombre limité de cycles.

Au cours d'un frittage sous pression, la pression appliquée lors du chauffage de la poudre permet d'obtenir une densification du joint en métal fritté, c'est-à-dire une réduction du nombre et de la taille des lacunes dans le joint qui offre donc une résistance en fatigue satisfaisante. La densification s'accompagne généralement d'une réduction de la taille de l'assemblage. La nécessité de mettre l'assemblage sous pression interdit cependant d'utiliser les procédés de frittage sous pression pour des composant délicats et fragiles, comme par exemple des résistances ou des thermistances formées d'oxydes métalliques pouvant être cassants. Par ailleurs, le frittage sous pression est difficilement industrialisable car l'application simultanée d'une pression identique sur tous les composants d'un circuit électronique est délicate à mettre en oeuvre surtout lorsque les composants ne présentent pas tous la même hauteur. Un frittage sous pression réalisé composant par composant serait quant à lui long et coûteux.

Il a été envisagé, notamment dans le document US2009/162557, de réaliser des assemblages de métal fritté sans pression, mettant notamment en oeuvre des pâtes à fritter. Selon ce document, un matériau de frittage comprenant des particules de métal comprenant au moins 80% de particules de métal dont la plus grande dimension est comprise entre 0,5 micromètres et 50 micromètres est disposé à une interface de jonction d'un premier et d'un deuxième élément. L'assemblage ainsi constituée subit deux étapes de chauffe successives. Cependant, en l'absence de pression, les joints obtenus avec ce mode d'assemblage sont de faible densité, poreux et offrent une faible résistance à la fatigue - notamment lorsqu'ils sont soumis à des cycles thermiques de grande amplitude. En effet, il a été constaté qu'une microstructure poreuse favorise les concentrations de contraintes. Or, les fissures se propagent d'autant plus vite dans un milieu que les contraintes dans celui-ci sont élevées.

### OBJET DE L'INVENTION

Un but de l'invention est de proposer un procédé d'assemblage de composants électroniques améliorant la résistance de l'assemblage aux cycles thermiques de grande amplitude.

### RESUME DE L'INVENTION

A cet effet, on prévoit, selon l'invention, un procédé d'assemblage par frittage métallique sans pression d'un premier élément avec un deuxième élément, le procédé comprenant les étapes suivantes :
a) une étape de préparation au cours de laquelle un matériau de frittage comprenant des particules de métal est disposé à une interface de jonction du premier et du deuxième élément, le matériau de frittage comprenant au moins 80% de particules de métal dont la plus grande dimension est comprise entre 0,5 micromètres et 50 micromètres ;
b) une étape de pré-frittage au cours de laquelle l'assemblage constitué par le premier élément, le deuxième élément et le matériau de frittage est chauffé pendant une première durée supérieure à cinq minutes à une première température supérieure à 200°C et strictement inférieure à la température d'activation de la diffusion aux joints de grains ;
c) une étape de densification au cours de laquelle l'assemblage est chauffé pendant une deuxième durée à une deuxième température supérieure ou égale à la température d'activation de la diffusion aux joints de grains .

On obtient alors un assemblage à l'aide d'un joint densifié sans application d'un effort sur les pièces, permettant donc d'assembler des pièces délicates et/ou fragiles. L'assemblage obtenu de la sorte offre une résistance satisfaisante aux sollicitations thermomécaniques. Un tel procédé permet une mise en oeuvre industrielle plus facile et plus rapide par rapport au frittage sous pression.

La détermination de la température d'activation de la diffusion aux joints de grains peut se faire par une étude dilatométrique, conformément à ce qui est décrit dans la description détaillée de l'invention.

Avantageusement, le matériau de frittage comprend au moins 80% de particules de métal dont la plus grande dimension est comprise entre 0,7 micromètres et 5 micromètres. Il est particulièrement aisé d'obtenir des assemblages hermétiques et résistants à la fatigue thermomécanique lorsque le matériau de frittage comprend au moins 80% de particules de métal de type « flake » (ou flocon en français). Préférentiellement, le matériau de frittage comprend au moins 80% de particules de métal dont le facteur de forme est inférieur à 0,3.

Avantageusement, les particules de métal sont des particules d'argent, de cuivre ou d'or.

Ceci permet de mettre à profit les spécificités propres à chaque métal (corrosion, conductivité, coût...).

Selon un mode particulier de réalisation, le procédé comprend également une étape de relaxation postérieure à l'étape de densification et au cours de laquelle l'assemblage est étuvé pendant une troisième durée à une température comprise entre 0,3T_{f} et 0,5T_{f}, où T_{f} est la température de fusion du matériau de frittage en degrés Kelvin.

Cette étape permet de libérer les contraintes internes en réduisant les concentrations de contrainte de l'assemblage et améliore ainsi sa tenue en fatigue.

D'autres caractéristiques et avantages de l'invention ressortiront à la lecture de la description qui suit de modes de mise en oeuvre particuliers non limitatifs de l'invention.

### BREVE DESCRIPTION DES DESSINS

Il sera fait référence aux dessins annexés parmi lesquels :
- la figure 1 est une représentation graphique de l'évolution de la vitesse de rétreint d'un matériau de frittage en fonction de la température ;
- la figure 2 est une représentation schématique en coupe transversale d'une première étape du procédé de l'invention ;
- la figure 3 est une vue identique à la figure 2 d'une deuxième étape du procédé de l'invention ;

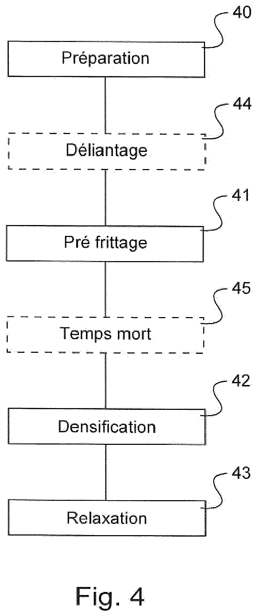

- la figure 4 est un logigramme présentant les différentes étapes du procédé selon l'invention ;
- la figure 5 est une vue schématique d'une particule métallique.

### DESCRIPTION DETAILLEE DE L'INVENTION

En préambule à la description qui suit d'un mode de mise en oeuvre du procédé selon l'invention, va être décrit un exemple de détermination de la température d'activation de la diffusion aux joints de grains Tt pour un matériau de frittage donné, ici une pâte à fritter 51 comprenant des particules métalliques.

Après avoir été séché pour s'assurer de l'évacuation des solvants qu'il contient, un échantillon du matériau de frittage est introduit dans un dilatomètre, ici sous la forme d'une pastille de deux millimètres de hauteur et de six millimètres de diamètre. Un chauffage selon une rampe de température, ici de 30°C par minute, démarrant à température ambiante est appliqué à l'échantillon. Au cours de l'échauffement de l'échantillon, sa variation de hauteur - ici un rétreint - est mesurée. Par le terme « rétreint », on désigne la contraction de l'échantillon de poudre au cours de son échauffement. On établit alors une courbe donnant la vitesse de rétreint (obtenue par la dérivée par rapport au temps de la valeur mesurée du rétreint) en fonction de la température.

La température d'activation de la diffusion aux joints de grains Tt est définie comme la plus faible température pour laquelle on observe une vitesse de rétreint d'au moins 2µm/min pour un échantillon de deux millimètres de hauteur.

Le dépassement de la température d'activation de la diffusion aux joints de grains Tt pendant l'étape de densification permet de s'assurer que la diffusion du métal des particules métalliques aux joints de grains est activée. Cela permet d'améliorer la fiabilité de l'assemblage.

Pour un matériau de frittage à base d'argent, la température Tt est comprise entre 340°C et 360°C. Il est à noter que la température Tt peut varier en fonction de la taille et de la géométrie des particules métalliques. Pour un matériau de frittage à base d'or ou de cuivre, la température Tt est nettement supérieure à 340°C.

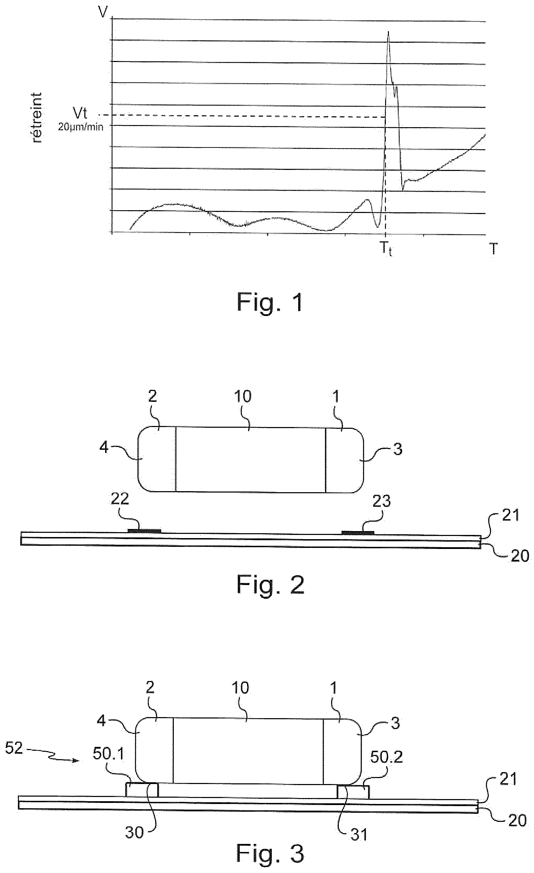

En référence à la figure 2, le procédé d'assemblage va être décrit en application à l'assemblage d'un premier élément, ici un condensateur multicouche en céramique (aussi désigné MLCC de l'anglais « Multi Layers Ceramic Capacitor »), généralement désigné 10, sur un deuxième élément, ici un substrat 20 rigide en alumine ayant la forme d'une plaque et pourvu d'une couche de métallisation 21 en argent.

Le condensateur 10 est de forme sensiblement parallélépipédique et comprend deux surfaces périphériques 1 et 2 respectivement pourvues d'une couche 3 et 4 de métallisation en argent.

Les surfaces 1 et 2 du condensateur 10 définissent, avec des zones 22 et 23 correspondant à la projection des surfaces 1 et 2 du condensateur 10 sur le substrat 20, deux interfaces 30 et 31 de jonction du condensateur 10 et du substrat 20.

Selon une première étape 40 de préparation, on dispose des plots 50.1 et 50.2 de pâte à fritter 51 respectivement aux interfaces 30 et 31 de jonction du condensateur 10 et du substrat 20. Les plots 50.1 et 50.2 recouvrent au moins les interfaces 30, 31 et ont une épaisseur comprise entre un micron et un millimètre. On obtient alors un assemblage 52 constitué de l'empilement du condensateur 10, des plots 50.1 et 50.2 de pâte à fritter 51, et du substrat 20.

Au sens de la présente demande, une pâte à fritter métallique est constituée d'une poudre métallique et d'un ou plusieurs solvants liquides ou pâteux. Une pâte à fritter métallique est dite micrométrique lorsque les particules qu'elle contient ont une plus grande dimension inférieure ou égale à un micromètre. Une pâte à fritter métallique est dite nanométrique lorsque les particules qu'elle contient ont une plus grande dimension inférieure ou égale à un nanomètre. La pâte à fritter 51 comprend ici des particules micrométriques d'argent.

Dans les étapes qui suivent du procédé selon l'invention, aucune pression en sus de celle provoquée par le poids du condensateur 10 n'est exercée sur les plots 50.1, 50.2 de pâte à fritter 51. En tout état de cause, le procédé d'assemblage par frittage sans pression selon l'invention implique que la pression qui serait appliquée sur le matériau de frittage par un élément (comme une presse par exemple) autre que les éléments constituants l'assemblage fabriqué soit inférieure à 0,5 Newton par millimètre carré.

Selon une deuxième étape 41 de pré-frittage, l'assemblage 52 est chauffé pendant une première durée D1 d'une heure à une première température T1 comprise entre 200°C et 300°C, c'est-à-dire une température strictement inférieure à la température d'activation de la diffusion aux joints de grains Tt et supérieure à 180°C. Au cours de l'étape 41 de pré-frittage, la température T1 peut varier tant qu'elle demeure inférieure à la température Tt. Au cours de cette étape, l'autodiffusion de surface prédomine par rapport aux autres modes d'autodiffusion. Préalablement à l'étape 41, il est possible de chauffer progressivement l'assemblage 52 de la température ambiante à la température T1. Il est également possible de procéder à un échauffement quasi-instantané de l'assemblage 52 en l'introduisant dans une enceinte préchauffée à la première température T1. L'étape 41 de pré-frittage a pour but de réaliser une consolidation préalable de l'assemblage 52 en créant une cohésion entre le condensateur 10, la pâte à fritter 51 et le substrat 20. L'étape 41 permet également de solidifier l'assemblage avant l'étape de densification. En effet, la densification produit un rétreint brutal qui peut provoquer la fissuration des joints d'attache et la décohésion des métallisations et du joint d'attache. L'ajout de l'étape de pré-frittage 41 améliore donc considérablement la fiabilité de l'électronique ainsi assemblée.

On procède alors à une troisième étape 42 de densification au cours de laquelle l'assemblage 52 est chauffé à une deuxième température T2 comprise entre 450°C et 550°C pendant une deuxième durée D2 de quarante-cinq minutes. Lors de cette étape, l'autodiffusion aux joints de grains et/ou l'autodiffusion en volume prédominent par rapport à l'autodiffusion de surface. Au cours de l'étape 42 de densification, la température T2 peut varier tant qu'elle demeure supérieure à la température Tt et inférieure à la température de fusion du matériau de frittage, ici la température de fusion de l'argent soit 961,8 °C. La transition entre l'étape 41 et l'étape 42 peut se faire en chauffant progressivement l'assemblage 52 de la température T1 à la température T2. Il est également possible de procéder au passage quasi-instantané de l'assemblage 52 depuis la première température T1 jusqu'à la deuxième température T2 en l'introduisant dans une enceinte préchauffée à la deuxième température T2.

L'étape 41 de pré-frittage réalise une consolidation de l'assemblage 52 qui lui permet de résister au rétreint se produisant pendant l'étape 42 de densification.

Avantageusement, le profil thermique de l'étape 41 est choisi de sorte à obtenir une augmentation du volume des grains et/ou des porosités comprise entre 0% et 100%. En d'autres termes, le profil thermique de l'étape 41 est choisi afin que le volume final (en fin d'étape 41) des grains ne dépasse pas le double de leur volume initial. Il en va de même pour les porosités dont le volume final ne doit pas dépasser le double de leur volume initial. Une telle étape 41 de pré-frittage permettra une efficacité accrue de l'étape 42 de densification.

Selon une quatrième étape 43 de relaxation, l'assemblage est étuvé à une troisième température T3 d'environ 300°C pendant une troisième durée de douze heures.

Cette quatrième étape 43 de relaxation est facultative et a pour but de relâcher les contraintes internes thermomécaniques créées lors des étapes précédentes. Il est à noter que le procédé d'assemblage de l'invention donne des résultats satisfaisants même en l'absence de l'étape de relaxation 43.

Au sens de la présente demande, l'étuvage est une opération au cours de laquelle on maintient un objet à une température de consigne constante, c'est-à-dire dont la variation est au maximum de dix pour cent de la valeur de la température de consigne.

Selon un deuxième mode de réalisation, on ajoute une étape intermédiaire 44 de déliantage entre la première étape 40 d'assemblage et la deuxième étape 41 de pré-frittage (représentée en pointillés sur la figure 3). Au cours de cette étape 44 de déliantage, l'assemblage 52 est étuvé à une quatrième température T4 comprise entre 50°C et 120°C pendant une durée comprise entre 5 minutes et 45 minutes. L'étape 44 de déliantage a pour but de purger la pâte à fritter 51 des solvants qu'elle contient par évaporation, sublimation et/ou combustion.

L'étape de déliantage 44 est facultative et le procédé d'assemblage de l'invention donne des résultats satisfaisants même en l'absence d'une étape de déliantage 44.

Selon un troisième mode de réalisation, il est possible d'ajouter une étape 45 de temps mort située entre la deuxième étape 41 de pré-frittage et la troisième étape 42 de densification. Au cours de cette étape 45 de temps mort, l'assemblage 52 est ramené à la température ambiante. Ceci permet, entre autres, de réaliser des contrôles sur l'assemblage 52 en sortie de pré-frittage sans avoir à prendre de précautions particulières de manipulation.

L'étape de temps mort 45 est facultative et le procédé d'assemblage de l'invention donne des résultats satisfaisants même en l'absence d'une étape de temps mort 45.

L'assemblage 52 obtenu par le procédé selon l'invention comprend un joint 53 de métal fritté qui présente une microstructure où la porosité a été totalement, ou quasi totalement, éliminée. Au contraire, un joint réalisé par frittage sans pression classique présente de nombreuses lacunes.

Des opérations préalables ou intermédiaires de surfaçage de l'interface visant à obtenir des états de surface particuliers (rugueux ou lisses) ou à appliquer un revêtement (métallisation ou autre) peuvent également permettre d'améliorer si besoin les performances mécaniques de l'assemblage.

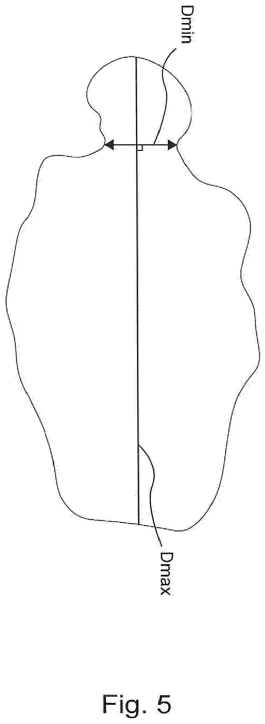

Parmi les poudres à fritter micrométriques, l'invention s'applique préférentiellement aux poudres comprenant au moins 80% de particules métalliques dont la plus grande dimension est comprise entre 0,5 et 50 micromètres, et très préférentiellement, à des poudres comprenant au moins 80% de particules métalliques dont la plus grande dimension est comprise entre 0,7 et 5 micromètres. En effet, les inventeurs se sont aperçus que l'utilisation de ces sélections de poudres à fritter, combinée avec le procédé de l'invention, permettait d'obtenir des joints frittés dont la porosité est particulièrement réduite par rapport aux procédés de l'art antérieur. Une porosité du joint fritté encore plus faible est obtenue par la sélection, au sein des plages de dimensions préférées précédentes, de poudres comprenant majoritairement des particules métalliques de type « flake ». Une particule est qualifiée de « flake » lorsque son facteur de forme f est inférieur à 0,5. Le facteur de forme f correspond au ratio de la plus grande dimension d'une particule Dmax et de la plus petite dimension Dmin de la particule mesurée orthogonalement à Dmax (cf. figure 5).

Ainsi, l'utilisation de poudres comprenant au moins 80% de particules métalliques dont la plus grande dimension Dmax est comprise entre 0,5 et 50 micromètres et dont le facteur de forme f est inférieur à 0,5 permet d'obtenir des joints frittés de porosité très faible. Une sélection, parmi ces poudres, retenant celles comprenant au moins 80% de particules métalliques dont la plus grande dimension est comprise entre 0,5 et 50 micromètres et dont le facteur de forme f est inférieur à 0,3 permet d'obtenir des joints frittés de porosité très faible. Une sélection plus poussée encore parmi ces poudres pour utiliser celles comprenant au moins 80% de particules métalliques dont la plus grande dimension est comprise entre 0,7 et 5 micromètres et dont le facteur de forme f est inférieur à 0,3 permet de réduire encore la porosité des joints frittés.

En effet, les inventeurs ont constaté de manière surprenante que, alors qu'un empilement compact de particules sphériques micrométriques et/ou nanométriques donne un taux de porosité avoisinant 26%, et qu'un empilement de particules micrométriques de type « flake » donne un taux de porosité voisin de 45%, le ratio R : « taille moyenne des particules métalliques de l'ensemble sur taille moyenne des pores de l'ensemble » obtenu après pré-frittage d'un joint à particules de type « flake » micrométriques est supérieur à celui obtenu après pré frittage d'un joint à particules sphériques micrométriques et/ou nanométriques. Or, la porosité d'un joint est d'autant plus réduite après frittage que le ratio R est élevé avant frittage. Ainsi, la sélection de particules de type « flake » dans une poudre à fritter comprenant au moins 80% de particules métalliques dont la plus grande dimension est comprise entre 0,5 et 50 micromètres amène à des joints frittés plus hermétiques et résistants à la fatigue thermomécanique que ceux obtenus à l'aide de poudre à fritter comprenant des particules métalliques nanométriques, sans qu'il soit nécessaire d'utiliser des températures de frittage élevées. Les poudres micrométriques étant moins coûteuses que les poudres nanométriques et moins dangereuses pour l'utilisateur, l'invention améliore significativement l'économie du procédé et les conditions de réalisation de celui-ci.

Des plages de températures et de durées préférées des étapes du procédé de l'invention pour un matériau de frittage comprenant des particules métalliques d'or et un matériau de frittage comprenant des particules métalliques d'argent figurent dans le tableau ci-dessous :

| | Déliantage Étape 44 | Pré-frittage Étape 41 | Densificati on Étape 42 | Relaxation Étape 43 |
|---|---|---|---|---|
| Argent | 50°C à 100°C | 200°C à 300°C | 450°C à 550°C | 220°C à 340°C |
| Or | 50°C à 100°C | 300°C à 400°C | 480°C à 700°C | 260°C à 400°C |
| Durée (quel que soit le type de métal des particules de la poudre) | 5 mn à 45 mn | Supérieure à 5 mn | Sans bornes | 30 mn à 30 h |

Bien entendu, l'invention n'est pas limitée aux modes de réalisation décrits mais englobe toute variante entrant dans le champ de l'invention telle que définie par les revendications.

En particulier :
- bien qu'ici l'échantillon de matériau de frittage ait été soumis à un test dilatométrique sous la forme d'une pastille de deux millimètres de hauteur et de six millimètres de diamètre auquel a été appliqué un chauffage selon une rampe de température de 30°C par minute, l'invention s'applique à d'autres formes d'échantillon, d'autres rampes de température ainsi qu'à d'autres modes de détermination d'une courbe donnant la vitesse de rétreint en fonction de la température. Toutefois, pour une hauteur d'échantillon h différente de deux millimètres, la vitesse de rétreint Vt correspondant à la température d'activation de la diffusion aux joints de grains est à adapter selon la formule mathématique suivante : Vt(en µm/min)=10*h(en mm).
- bien qu'ici le deuxième élément soit un substrat plan rigide en alumine, l'invention s'applique également à un deuxième élément de nature différente comme par exemple d'autres types de céramiques telles que le nitrure d'aluminium, le nitrure de silicium ou l'oxyde de béryllium, ou encore un substrat flexible en matériau polymère ou encore un substrat concave ou convexe de forme quelconque ;

- bien qu'ici le deuxième élément soit un substrat en céramique plan, l'invention s'applique également à un deuxième élément de nature différente en silicium ou en acier inoxydable recouvert d'un matériau électriquement isolant par exemple ;
- bien qu'ici le premier élément soit un condensateur multicouche en céramique, l'invention s'applique également à un premier élément de nature différente comme par exemple, un condensateur électrolytique, une résistance, une thermistance, un composant en silicium, un capteur de pression capacitif ou piézorésistif, un dispositif à semiconducteur ayant une bande interdite supérieure à 1,5 eV à 25°C comme, entre autres, le carbure de silicium ou le nitrure de gallium ;
- bien qu'ici le condensateur soit de forme sensiblement parallélépipédique, l'invention s'applique également à des composants électroniques présentant des formes différentes comme par exemple une forme cylindrique ou quelconque ;
- bien qu'ici le substrat soit pourvu d'une couche de métallisation en argent pour un frittage à l'aide d'un matériau de frittage comprenant de l'argent, l'invention s'applique également à un substrat revêtu d'une métallisation par un métal différent de celui du matériau de frittage ;
- bien qu'ici l'assemblage comprenne deux interfaces de jonction, l'invention s'applique également à un assemblage comprenant un nombre différent d'interfaces de jonction comme par exemple une seule interface de jonction ou plus de deux ;
- bien qu'ici le matériau de frittage soit une pâte à fritter comprenant des particules d'argent, l'invention s'applique également à d'autres types de matériau à fritter comme par exemple des poudres de frittage. Le procédé d'assemblage selon l'invention s'applique également à des matériaux de frittage comprenant des particules de métaux différents comme par exemple des particules d'or, de cuivre ou un mélange de celles-ci ;
- bien qu'ici le matériau de frittage soit une pâte à fritter comprenant des particules de métal pur, l'invention s'applique également à d'autres types de matériaux à fritter comme par exemple des poudres de frittage constituées d'alliages métalliques, de solutions solides métalliques ou de mélanges de différentes poudres ;
- bien qu'ici, l'étape de relaxation soit opérée pendant une durée de douze heures, le procédé selon l'invention peut inclure des étapes de relaxation dont la durée peut varier entre trente minutes et trente heures ;
- bien qu'ici l'étape de densification ait une deuxième durée de quarante-cinq minutes, l'invention s'applique également à toute étape de densification quelle que soit sa durée ;
- bien qu'ici, le matériau de frittage comprenne des particules de métal micrométriques, l'invention s'applique également à d'autres types de matériau comportant des particules de métal dont la plus grande dimension est inférieure à cinquante micromètres, comme par exemple des matériaux de frittage comprenant des particules de métal nanométriques ;
- bien qu'ici, la première température appliquée au cours de l'étape de pré-frittage soit comprise entre 200°C et 300°C, l'invention s'applique également à une étape de pré-frittage au cours de laquelle l'assemblage est chauffé à des températures différentes, tant que celles-ci demeurent strictement inférieures à la température d'activation de la diffusion aux joints de grains.-Cette température ne devra pas être inférieure à 200°C.
- bien qu'ici, la deuxième température appliquée au cours de l'étape de densification soit comprise entre 450°C et 550°C, l'invention s'applique également à une étape de densification au cours de laquelle l'assemblage est chauffé à une température différente, tant que celle-ci demeure supérieure à la température de transition entre le domaine de frittage par diffusion de surface et le domaine de frittage par diffusion aux joints de grains tout en restant inférieure à la température de fusion du matériau de frittage ;
- bien qu'ici, la troisième température appliquée au cours de l'étape de relaxation soit d'environ 300°C, l'invention s'applique également à une étape de relaxation au cours de laquelle l'assemblage est chauffé à une température différente, tant que celle-ci demeure comprise entre 0,3.T_{f} et 0,5.T_{f}, où T_{f} est la température de fusion du métal ou de l'alliage du matériau de frittage en degrés Kelvin.

## Revendications

1. Procédé d'assemblage par frittage métallique sans pression d'un premier élément (10) avec un deuxième élément (20), le procédé comprenant les étapes suivantes :
a) une étape de préparation (40) au cours de laquelle un matériau de frittage (50.1, 50.2) comprenant des particules de métal est disposé à une interface de jonction (30 ; 31) du premier élément (10) et du deuxième élément (20), le matériau de frittage (50.1, 50.2) comprenant majoritairement des particules de métal dont la plus grande dimension est comprise entre 0,5 micromètres et 50 micromètres ;
b) une étape de pré-frittage (41) au cours de laquelle l'assemblage (52) constitué par le premier élément (10), le deuxième élément (20) et le matériau de frittage (50.1, 50.2) est chauffé pendant une première durée supérieure à cinq minutes à une première température strictement inférieure à la température (Tt) d'activation de la diffusion aux joints de grains ;
c) une étape de densification (42) au cours de laquelle l'assemblage (52) est chauffé pendant une deuxième durée à une deuxième température supérieure ou égale à la température (Tt) température d'activation de la diffusion aux joints de grains,
le matériau de frittage (50.1, 50.2) comprenant au moins 80% de particules de métal de type « flake » dont le ratio de la plus grande dimension (Dmax) de la particule de métal et de la plus petite dimension (Dmin) de la particule de métal mesurée orthogonalement à la plus grande dimension (Dmax) de la particule de métal est inférieur à 0,3

2. Procédé selon la revendication 1, dans lequel le matériau de frittage (50.1, 50.2) comprend majoritairement des particules de métal dont la plus grande dimension est comprise entre 0,7 micromètres et 5 micromètres.

3. Procédé selon la revendication 2, dans lequel le matériau de frittage (50.1, 50.2) comprend au moins 80% de particules de métal dont la plus grande dimension est comprise entre 0,7 micromètres et 5 micromètres.

4. Procédé selon l'une quelconque des revendications précédentes, dans lequel les particules de métal sont des particules d'argent et au cours duquel la première température est comprise entre 200°C et 300°C.

5. Procédé selon l'une quelconque des revendications précédentes, dans lequel les particules de métal sont des particules d'argent et au cours duquel la deuxième température est comprise entre 450°C et 550°C.

6. Procédé selon l'une quelconque des revendications précédentes, dans lequel les particules de métal sont des particules d'or et au cours duquel la première température est comprise entre 300°C et 400°C.

7. Procédé selon l'une quelconque des revendications 1 à 3, dans lequel les particules de métal sont des particules d'or et au cours duquel la deuxième température est comprise entre 480°C et 700°C.

8. Procédé selon l'une quelconque des revendications précédentes, dans lequel on fait varier la première température pendant la première durée .

9. Procédé selon l'une quelconque des revendications précédentes, dans lequel on fait varier la deuxième température pendant la deuxième durée .

10. Procédé selon l'une quelconque des revendications précédentes, comprenant également une étape de relaxation (43), postérieure à l'étape de densification (42), au cours de laquelle l'assemblage (52) est étuvé à une température comprise entre 0,3 Tf et 0,5 Tf, où Tf est la température de fusion du matériau de frittage (50.1, 50.2) en degrés Kelvin, pendant une troisième durée .

11. Procédé selon la revendication 10, dans lequel la troisième durée est comprise entre trente minutes et trente heures.

12. Procédé selon l'une quelconque des revendications précédentes, dans lequel le matériau de frittage (50.1, 50.2) est une poudre.

13. Procédé selon la revendication 1, dans lequel le matériau de frittage (50.1, 50.2) est une pâte.

14. Procédé selon l'une quelconque des revendications précédentes, comprenant une étape de temps mort (45) située entre les étapes de pré-frittage (41) et de densification (42) au cours de laquelle l'assemblage (52) est ramené à la température ambiante.

15. Procédé selon l'une quelconque des revendications précédentes, comprenant une étape de déliantage (44) réalisée entre les étapes de préparation (40) et de pré-frittage (41), au cours de laquelle l'assemblage (52) est étuvé à une température comprise entre 50°C et 100°C.

16. Assemblage (52) obtenu par le procédé selon l'une quelconque des revendications 1 à 15.

## Patentansprüche

1. Verfahren zum Zusammenfügen eines ersten Elements (10) mit einem zweiten Element (20) durch Metallsintern ohne Druck, wobei das Verfahren die folgenden Schritte umfasst:
a) einen Vorbereitungsschritt (40), während dessen ein Sintermaterial (50.1, 50.2), das Metallpartikel umfasst, an einer Verbindungsschnittstelle (30; 31) des ersten Elements (10) und des zweiten Elements (20) angeordnet wird, wobei das Sintermaterial (50.1, 50.2) mehrheitlich Metallpartikel umfasst, deren größte Abmessung zwischen 0,5 Mikrometer und 50 Mikrometer beträgt;
b) einen Vorsinterschritt (41), während dessen die Verbindung (52), die aus dem ersten Element (10), dem zweiten Element (20) und dem Sintermaterial (50.1, 50.2) gebildet ist, für eine erste Dauer, die länger als fünf Minuten ist, auf eine erste Temperatur erwärmt wird, die streng niedriger als die Aktivierungstemperatur (Tt) der Diffusion an den Korngrenzen ist;
c) einen Verdichtungsschritt (42), während dessen die Verbindung (52) für eine zweite Dauer auf eine zweite Temperatur erwärmt wird, die höher oder gleich der Aktivierungstemperatur (Tt) der Diffusion an den Korngrenzen ist,
wobei das Sintermaterial (50.1, 50.2) mindestens 80 % Metallpartikel vom Typ "Flake" umfasst, deren Verhältnis der größten Abmessung (Dmax) des Metallpartikels zur kleinsten Abmessung (Dmin) des Metallpartikels, gemessen senkrecht zur größten Abmessung (Dmax) des Metallpartikels, weniger als 0,3 beträgt.

2. Verfahren nach Anspruch 1, bei dem das Sintermaterial (50.1, 50.2) mehrheitlich Metallpartikel umfasst, deren größte Abmessung zwischen 0,7 Mikrometer und 5 Mikrometer beträgt.

3. Verfahren nach Anspruch 2, bei dem das Sintermaterial (50.1, 50.2) mindestens 80 % Metallpartikel umfasst, deren größte Abmessung zwischen 0,7 Mikrometer und 5 Mikrometer beträgt.

4. Verfahren nach einem der vorhergehenden Ansprüche, bei dem die Metallpartikel Silberpartikel sind und während dessen die erste Temperatur zwischen 200°C und 300°C beträgt.

5. Verfahren nach einem der vorhergehenden Ansprüche, bei dem die Metallpartikel Silberpartikel sind und während dessen die zweite Temperatur zwischen 450°C und 550°C beträgt.

6. Verfahren nach einem der vorhergehenden Ansprüche, bei dem die Metallpartikel Goldpartikel sind und während dessen die erste Temperatur zwischen 300°C und 400°C beträgt.

7. Verfahren nach einem der Ansprüche 1 bis 3, bei dem die Metallpartikel Goldpartikel sind und während dessen die zweite Temperatur zwischen 480°C und 700°C beträgt.

8. Verfahren nach einem der vorhergehenden Ansprüche, bei dem man die erste Temperatur während der ersten Dauer variiert.

9. Verfahren nach einem der vorhergehenden Ansprüche, bei dem man die zweite Temperatur während der zweiten Dauer variiert.

10. Verfahren nach einem der vorhergehenden Ansprüche, ferner umfassend einen Relaxationsschritt (43) nach dem Verdichtungsschritt (42), während dessen die Verbindung (52) auf eine Temperatur zwischen 0,3 Tf und 0,5 Tf getrocknet wird, wobei Tf die Schmelztemperatur des Sintermaterials (50.1, 50.2) in Grad Kelvin ist, für eine dritte Dauer.

11. Verfahren nach Anspruch 10, bei dem die dritte Dauer zwischen 30 Minuten und 30 Stunden beträgt.

12. Verfahren nach einem der vorhergehenden Ansprüche, bei dem das Sintermaterial (50.1, 50.2) ein Pulver ist.

13. Verfahren nach Anspruch 1, bei dem das Sintermaterial (50.1, 50.2) eine Paste ist.

14. Verfahren nach einem der vorhergehenden Ansprüche, umfassend einen zwischen dem Vorsinterschritt (41) und dem Verdichtungsschritt (42) liegenden Totzeitschritt (45), während dessen die Verbindung (52) auf die Umgebungstemperatur zurückgebracht wird.

15. Verfahren nach einem der vorhergehenden Ansprüche, umfassend einen zwischen dem Vorbereitungsschritt (40) und dem Vorsinterschritt (41) durchgeführten Entbinderungsschritt (44), während dessen die Verbindung (52) auf eine Temperatur zwischen 50°C und 100°C getrocknet wird.

16. Verbindung (52), die durch das Verfahren nach einem der Ansprüche 1 bis 15 erhalten wird.

## Claims

1. An assembly method for assembling a first element (10) to a second element (20) by pressureless metal sintering, the method comprising the following steps:
a) a preparation step (40) during which a sintering material (50.1, 50.2) comprising metal particles is arranged at a bond interface (30; 31) of the first element (10) and of the second element (20), the sintering material (50.1, 50.2)comprising predominantly metal particles having a greatest dimension lying in the range 0.5 um to about 50 µm;
b) a pre-sintering step (41) during which the assembly (52) constituted by the first element (10), the second element (20), and the sintering material (50.1, 50.2) is heated for a first duration that is longer than five minutes at a first temperature (T1) that is strictly lower than the temperature (Tt) for activating diffusion at the grain boundaries;
c) a densification step (42) during which the assembly (52) is heated for a second duration at a second temperature that is higher than or equal to the temperature (Tt) for activating diffusion at the grain boundaries,
the sintering material (50.1, 50.2) comprising at least about 80% flake-type metal particles having a ratio of the greatest dimension (Dmax) of the particle divided by the smallest dimension (Dmin) of the particle measured orthogonally to the greatest dimension (Dmax) that is less than 0.3.

2. A method according to claim 1, wherein the sintering material (50.1, 50.2) comprises predominantly metal particles having a greatest dimension lying in the range 0.7 um to 5 µm.

3. A method according to claim 2, wherein the sintering material (50.1, 50.2) comprises at least 80% metal particles having a greatest dimension lying in the range 0.7 µm to 5 µm.

4. A method according to any preceding claim, wherein the metal particles are silver particles and during which the first temperature lies in the range 200°C to 300°C.

5. A method according to any preceding claim, wherein the metal particles are silver particles and during which the second temperature lies in the range 450°C to 550°C.

6. A method according to any preceding claim, wherein the metal particles are gold particles and during which the first temperature lies in the range 300°C to 400°C.

7. A method according to any preceding claim 1 to 3, wherein the metal particles are gold particles and during which the second temperature lies in the range 480°C to 700°C.

8. A method according to any preceding claim, wherein the first temperature is varied during the first duration.

9. A method according to any preceding claim, wherein the second temperature is varied during the second duration.

10. A method according to any preceding claim, further comprising a relaxation step (43), subsequent to the densification step (42), during which the assembly (52) is stoved at a temperature lying in the range 0.3 Tf to 0.5 Tf, where Tf is the melting temperature of the sintering material (50.1, 50.2) in degrees Kelvin, for a third duration.

11. A method according to claim 10, wherein the third duration lies in the range thirty minutes to thirty hours.

12. A method according to any preceding claim, wherein the sintering material (50.1, 50.2) is a powder.

13. A method according to claim 1, wherein the sintering material (50.1, 50.2) is a paste.

14. A method according to any preceding claim, comprising an idle-time step (45) situated between the pre-sintering (41) and densification (42) steps during which the assembly (52) is returned to ambient temperature.

15. A method according to any preceding claim, comprising a debinding step (44) that is performed between the preparation (40) and pre-sintering (41) steps, during which the assembly (52) is stoved at a temperature lying in the range 50°C to 100°C.

16. An assembly (52) obtained by the method according to any one of claims 1 to 15.
